# EUROPÄISCHE PATENTANMELDUNG

(11) **EP 3 531 809 A1**
(43) Veröffentlichungstag der Anmeldung: **28.08.2019**
(21) Anmeldenummer: 19401009.6
(22) Anmeldetag: 20.02.2019
(51) Int. Cl.: H05K 5/06

(54) **VORRICHTUNG ZUM ABDICHTEN EINER AUSNEHMUNG IN EINEM OBJEKT**

(30) Priorität: 27.02.2018 DE 102018104370
(71) Anmelder: Amazonen-Werke H. Dreyer GmbH & Co. KG, 49205 Hasbergen (DE)
(72) Erfinder: Krabbe, Ulrich, 49205 Hasbergen (DE); Hofter, Rainer, 49143 Bissendorf (DE); Kleine-Hartlage, Hubertus, 49186 Bad Iburg (DE)

(57) **Zusammenfassung**

Die Erfindung betrifft eine Vorrichtung (10,10a, 10b) zum Abdichten einer Ausnehmung (52, 52a, 52b) in einem Objekt (50), mit einem umlaufenden Aufnahmeteil (12), welches dazu eingerichtet ist, an der Außenkontur der Ausnehmung (52, 52a, 52b) an dem Objekt (50) befestigt zu werden, und einem Deckel (30), welcher dazu eingerichtet ist, reversibel und zerstörungsfrei lösbar in das Aufnahmeteil (12) eingesetzt zu werden, wobei das Aufnahmeteil (12) eine Kontaktfläche (14) aufweist, welche im eingesetzten Zustand des Deckels (30) mit zumindest einem Kontaktabschnitt (42a-42c) des Deckels (30) in Kontakt steht und der die Kontaktfläche (14) tragende Materialabschnitt (16) des Aufnahmeteils (12) und der zumindest eine Kontaktabschnitt (42a-42c) des Deckels (30) unterschiedliche Verformungseigenschaften aufweisen.

## Beschreibung

Die Erfindung betrifft eine Vorrichtung zum Abdichten einer Ausnehmung in einem Objekt nach dem Oberbegriff des Patentanspruchs 1 und ein landwirtschaftliches Gerät nach dem Oberbegriff des Patentanspruchs 13.

Moderne landwirtschaftliche Geräte, wie beispielsweise Düngerstreuer, weisen regelmäßig feuchtigkeitsempfindliche Elektronikeinheiten auf, welche zur Vermeidung eines Funktionsausfalls des landwirtschaftlichen Geräts vor dem Kontakt mit Flüssigkeit sowie übermäßiger Feuchtigkeit zu schützen sind. Zur Montage oder Wartung der Elektronikeinheiten sind diese üblicherweise in unmittelbarer Nähe von Ausnehmungen angeordnet, in welche ein Stopfen oder Deckel reversibel und zerstörungsfrei einsetzbar ist. Auf diese Weise werden die Elektronikeinheiten einerseits vor Feuchtigkeit geschützt und sind andererseits von außen zugänglich.

Aus dem Stand der Technik sind unterschiedliche Verschlussstopfen zum Verschließen und/oder Abdichten entsprechender Ausnehmungen bekannt. Die Druckschrift DE 603 15 594 T3 schlägt einen Behälterverschlussstopfen mit einem umlaufenden Aufnahmeteil vor, wobei der Verschlussstopfen mittels eines Gewindes in das Aufnahmeteil eindrehbar ist. Außerdem ist aus der Druckschrift DE 89 04 043 U1 ein Stopfen für den Verschluss der offenen Endseiten von Hohlprofilen bekannt. Darüber hinaus offenbart die Druckschrift DE 1 525 790 A1 einen Verschlussstopfen für runde Öffnungen in Maschinenteilen oder für runde Rohrenden.

Diese und andere bekannte Lösungen erlauben jedoch keine zufriedenstellende Abdichtung von Ausnehmungen und/oder bedingen vergleichsweise hohe Produktionskosten, sodass deren Einsatz in einer Vielzahl von Anwendungsbereichen ausscheidet.

Die der Erfindung zugrundeliegende Aufgabe besteht somit darin, die Abdichtung von Ausnehmungen zu verbessern, wobei die Abdichtung reversibel und zerstörungsfrei lösbar sein und vergleichsweise geringe Produktionskosten bedingen soll.

Die Aufgabe wird gelöst durch eine Vorrichtung der eingangs genannten Art, wobei ein in die Ausnehmung einzusetzendes umlaufendes Aufnahmeteil eine Kontaktfläche aufweist, welche im eingesetzten Zustand eines Deckels mit zumindest einem Kontaktabschnitt des Deckels in Kontakt steht. Erfindungsgemäß weisen der die Kontaktfläche tragende Materialabschnitt des Aufnahmeteils und der zumindest eine Kontaktabschnitt des Deckels unterschiedliche Verformungseigenschaften auf.

Die Erfindung macht sich die Erkenntnis zunutze, dass durch die unterschiedlichen Verformungseigenschaften beim Einsetzen des Deckels in das umlaufende Aufnahmeteil entweder der die Kontaktfläche tragende Materialabschnitt des Aufnahmeteils oder der zumindest eine Kontaktabschnitt des Deckels derart verformt wird, dass sich zwischen der Kontaktfläche des Aufnahmeteils und dem Kontaktabschnitt des Deckels ein Abdichtbereich ergibt, welcher für eine hohe Dichtwirkung sorgt. Durch die unterschiedlichen Verformungseigenschaften des die Kontaktfläche tragenden Materialabschnitts und des zumindest einen Kontaktabschnitts des Deckels wird außerdem das Lösen des Deckels von dem Aufnahmeteil erheblich vereinfacht, sodass der Deckel sich trotz der hohen Dichtwirkung im eingesetzten Zustand mit einem vergleichsweise geringen Kraftaufwand lösen lässt. Auf diese Weise kann der hinter der Ausnehmung befindliche Bauraum für Montage- und/oder Wartungsarbeiten zugänglich gemacht werden.

Der die Kontaktfläche tragende Materialabschnitt des Aufnahmeteils und der zumindest eine Kontaktabschnitt des Deckels weisen vorzugsweise unterschiedliche Härtegrade auf. Alternativ oder zusätzlich sind der die Kontaktfläche tragende Materialabschnitt des Aufnahmeteils und der zumindest eine Kontaktabschnitt des Deckels aus unterschiedlichen Materialien, insbesondere aus unterschiedlichen Kunststoffen, ausgebildet.

In einer bevorzugten Ausführungsform der erfindungsgemäßen Vorrichtung ist der die Kontaktfläche tragende Materialabschnitt des Aufnahmeteils aus einem weicheren Material ausgebildet als der zumindest eine Kontaktabschnitt des Deckels. Da der die Kontaktfläche tragende Materialabschnitt des Aufnahmeteils aus einem weicheren Material ausgebildet ist als der zumindest eine Kontaktabschnitt des Deckels, bedingt das Einsetzen des Deckels in das Aufnahmeteil eine stärkere Verformung des die Kontaktfläche tragenden Materialabschnitts des Aufnahmeteils als des zumindest einen Kontaktabschnitts des Deckels. Vorzugsweise sind das Aufnahmeteil und der Deckel derart ausgebildet, dass der Deckel beim Einsetzen in das Aufnahmeteil im Wesentlichen keine Formveränderung erfährt. Dadurch, dass der die Kontaktfläche tragende Materialabschnitt des Aufnahmeteils beim Einsetzen des Deckels in das Aufnahmeteil verformt wird, bildet sich zwischen dem die Kontaktfläche tragenden Materialabschnitt des Aufnahmeteils und dem zumindest einen Kontaktabschnitt des Deckels eine Druckspannung aus, welche die Dichtwirkung verbessert und die Stabilität des Deckels innerhalb des Aufnahmeteils steigert.

In einer weiteren bevorzugten Ausführungsform der erfindungsgemäßen Vorrichtung sind die Kontaktfläche des Aufnahmeteils und/oder der zumindest eine Kontaktabschnitt des Deckels umlaufend ausgebildet. Auf diese Weise wird ein umlaufender Abdichtbereich ausgebildet, welcher eine flüssigkeitsdichte und/oder gasdichte Verbindung bereitstellt. Durch den umlaufenden Abdichtbereich wird ein Feuchtigkeitsdurchtritt in feuchten Umgebungen vermieden. Ferner wird durch den umlaufenden Abdichtbereich ein Flüssigkeitsdurchtritt während der Reinigung des Objekts mit einem Hochdruckreiniger vermieden. Somit ist der hinter der Ausnehmung befindliche Bauraum spritzwassergeschützt. Ferner kann auch ein mit Druck beaufschlagter Flüssigkeitsstrahl keinen Flüssigkeitseintritt in den hinter der Ausnehmung befindlichen Bauraum verursachen.

Außerdem ist eine erfindungsgemäße Vorrichtung bevorzugt, bei welcher der zumindest eine Kontaktabschnitt des Deckels ein Übermaß gegenüber der Kontur der Kontaktfläche des Aufnahmeteils und/oder der Außenkontur der Ausnehmung in dem Objekt aufweist. Aufgrund des Übermaßes kommt es beim Einsetzen des Deckels in das Aufnahmeteil zu einer elastischen und/oder plastischen Verformung des die Kontaktfläche tragenden Materialabschnitts des Aufnahmeteils und/oder des zumindest einen Kontaktabschnitts des Deckels. Es wird somit eine form- und/oder kraftschlüssige Verbindung zwischen dem Deckel und dem Aufnahmeteil erzeugt. Vorzugsweise verkrallt sich der zumindest eine Kontaktabschnitt des Deckels in die Kontaktfläche des Aufnahmeteils. Der Deckel kann auch direkt in die Ausnehmung in dem Objekt eingesetzt werden, ohne dass zuvor ein Aufnahmeteil befestigt wurde. Vorzugsweise wird das Aufnahmeteil aufgrund des Übermaßes des zumindest einen Kontaktabschnitts des Deckels beim Einsetzen gegen die Kontur der Ausnehmung in dem Objekt gedrückt.

In einer anderen Ausführungsform der erfindungsgemäßen Vorrichtung sind der Deckel und/oder das Aufnahmeteil jeweils teilweise oder vollständig aus Kunststoff ausgebildet. Vorzugsweise ist das Aufnahmeteil teilweise oder vollständig aus einem Elastomer ausgebildet. Vorzugsweise ist der Deckel teilweise oder vollständig aus einem Thermoplast ausgebildet.

In einer weiteren Ausführungsform der erfindungsgemäßen Vorrichtung sind der Deckel und/oder das Aufnahmeteil jeweils einstückig ausgebildet. Insbesondere sind der Deckel und/oder das Aufnahmeteil jeweils als Spritzgussteile ausgebildet. Die Herstellung entsprechender Spritzgussteile bedingt einen vergleichsweise geringen Kostenaufwand und erlaubt die Realisierung vergleichsweise komplexer Geometrien. Somit erlaubt das Spritzgussverfahren die Herstellung einer erfindungsgemäßen Vorrichtung mit einer hohen Dichtwirkung zu geringen Herstellungskosten.

In einer Weiterbildung der erfindungsgemäßen Vorrichtung umfasst der Deckel eine sich nach außen erstreckende und vorzugsweise umlaufende Rippe, welche einen Kontaktabschnitt des Deckels trägt. Vorzugsweise ist eine umlaufende Außenkante der Rippe als Kontaktabschnitt des Deckels ausgebildet. Die Rippe des Deckels kann beispielsweise eine ausgeprägte eckige Außenkante oder einen abgerundeten Außenbereich aufweisen.

Außerdem ist eine erfindungsgemäße Vorrichtung vorteilhaft, bei welcher der Deckel mehrere voneinander beabstandete, sich nach außen erstreckende und vorzugsweise umlaufende Rippen umfasst, wobei jede Rippe jeweils einen Kontaktabschnitt des Deckels trägt. Durch die mehreren Rippen ergeben sich mehrere Kontaktabschnitte, welche nach dem Einsetzen des Deckels in das Aufnahmeteil mit der Kontaktfläche des Aufnahmeteils in Kontakt stehen. Vorzugsweise ergeben sich durch die mehreren jeweils einen Kontaktabschnitt tragenden Rippen mehrere, vorzugsweise umlaufende, Abdichtbereiche zwischen dem Aufnahmeteil und dem Deckel. Vorzugsweise weisen einzelne Rippen unterschiedliche Außenkonturumfänge auf. Durch die unterschiedlichen Außenkonturumfänge wird der die Kontaktfläche tragende Materialabschnitt des Aufnahmeteils beim Einsetzen des Deckels in das Aufnahmeteil von den einzelnen Rippen unterschiedlich stark verformt. Alternativ oder zusätzlich werden die Rippen durch die unterschiedlichen Außenkonturumfänge beim Einsetzen des Deckels in das Aufnahmeteil unterschiedlich stark verformt. Durch die unterschiedlichen Außenkonturumfänge der Rippen ergeben sich unterschiedliche Druckspannungen zwischen den jeweiligen Rippen und der Kontaktfläche des Aufnahmeteils.

In einer weiteren bevorzugten Ausführungsform der erfindungsgemäßen Vorrichtung ist die eine oder sind die mehreren Rippen an einem vorzugsweise umlaufenden Kragen angeordnet, welcher sich nach Einsetzen des Deckels zumindest teilweise durch die Ausnehmung in dem Objekt erstreckt. Vorzugsweise erstreckt sich der Kragen nach Einsetzen des Deckels zumindest teilweise durch die Öffnung des umlaufenden Aufnahmeteils, in welche der Deckel eingesetzt wird.

Darüber hinaus ist eine erfindungsgemäße Vorrichtung bevorzugt, bei welcher der Deckel ein sich über das Aufnahmeteil nach außen erstreckenden Überstand aufweist, welcher das Aufnahmeteil im eingesetzten Zustand des Deckels zumindest abschnittsweise verdeckt. Durch den Überstand wird das Aufnahmeteil vor äußerer mechanischer Beanspruchung geschützt, beispielsweise dem Strahl eines Hochdruckreinigers. Somit wird ein Herausdrücken des Aufnahmeteils aus der Ausnehmung in dem Objekt vermieden. Vorzugsweise weist der Deckel in dem die Ausnehmung bedeckenden Abschnitt ein oder mehrere Versteifungselemente, wie etwa Versteifungsrippen, auf.

Es ist außerdem eine erfindungsgemäße Vorrichtung vorteilhaft, bei welcher das Aufnahmeteil eine obere Befestigungslippe, welche eine obere Anschlagsfläche für das Objekt ausbildet, und/oder eine untere Befestigungslippe, welche eine untere Anschlagsfläche für das Objekt ausbildet, aufweist. Zwischen der oberen Befestigungslippe und der unteren Befestigungslippe ist vorzugsweise eine Aufnahmenut angeordnet, welche zur Aufnahme des die Ausnehmung umgebenden Bereichs des Objekts ausgebildet ist. Die Höhe der Aufnahmenut entspricht vorzugsweise dem Abstand der oberen Anschlagsfläche und der unteren Anschlagsfläche. Beispielsweise weist die Aufnahmenut eine Höhe in dem Bereich von 2mm bis 10mm auf. Vorzugsweise weisen die obere Anschlagsfläche und die untere Anschlagsfläche einen Abstand in dem Bereich von 2mm bis 10mm auf. Vorzugsweise beträgt das Verhältnis zwischen der Höhe der Aufnahmenut beziehungsweise dem Abstand der oberen Anschlagsfläche und der unteren Anschlagsfläche und der Gesamthöhe des Aufnahmeteils in dem Bereich von 1:10 bis 9:10. Durch die Verwendung unterschiedlicher Spritzwerkzeuge lassen sich mit einem vergleichsweise geringen Aufwand unterschiedliche Geometrien für das Aufnahmeteil umsetzen, sodass die Vorrichtung zur Abdichtungen von Ausnehmungen in Objekten unterschiedlicher Materialstärke Verwendung finden kann. Aufgrund der Elastizität des Aufnahmeteils kann bereits ein und dasselbe Aufnahmeteil in Ausnehmungen in Objekten unterschiedlicher Materialstärke eingesetzt werden.

Ferner ist eine erfindungsgemäße Vorrichtung bevorzugt, bei welcher der Deckel werkzeuglos von dem Aufnahmeteil gelöst und entnommen werden kann. Vorzugsweise weist der Deckel eine Grifflasche auf, welche von einem Benutzer zum Lösen und Entnehmen des Deckels händisch greifbar ist. Vorzugsweise ist die Klemmkraft zwischen dem eingesetzten Deckel und dem Aufnahmeteil derart bemessen, dass der Deckel händisch und ohne Demontagewerkzeug von dem Aufnahmeteil getrennt werden kann.

Die der Erfindung zugrundeliegende Aufgabe wird ferner durch ein landwirtschaftliches Gerät der eingangs genannten Art gelöst, wobei die Vorrichtung zum Abdichten der Ausnehmung des Gehäuses des erfindungsgemäßen landwirtschaftlichen Geräts nach einer der vorstehend beschriebenen Ausführungsformen ausgebildet ist. Hinsichtlich der Vorteile und Modifikationen des erfindungsgemäßen landwirtschaftlichen Geräts wird zunächst auf die Vorteile und Modifikationen der erfindungsgemäßen Vorrichtung zum Abdichten einer Ausnehmung in einem Objekt verwiesen.

In einer bevorzugten Ausführungsform des erfindungsgemäßen landwirtschaftlichen Geräts ist das landwirtschaftliche Gerät als Düngerstreuer ausgebildet, wobei das Gehäuse vorzugsweise als Hauptrohr des Düngerstreuers ausgebildet ist, in welchem die als Maschinenrechner ausgebildete Elektronikeinheit angeordnet ist.

Weitere Einzelheiten der Erfindung sind der Figurenbeschreibung und den Zeichnungen zu entnehmen. Es zeigen
- Fig. 1: ein Ausführungsbeispiel des erfindungsgemäßen landwirtschaftlichen Geräts in einer Rückansicht;
- Fig. 2: ein Aufnahmeteil einer erfindungsgemäßen Vorrichtung in einer Draufsicht;
- Fig. 3: das in der Fig. 2 dargestellte Aufnahmeteil in einer Schnittdarstellung;
- Fig. 4: einen Deckel einer erfindungsgemäßen Vorrichtung in einer Rückansicht;
- Fig. 5: den in der Fig. 4 dargestellten Deckel in einer perspektivischen Darstellung; und
- Fig. 6: ein Ausführungsbeispiel der erfindungsgemäßen Vorrichtung in einer Schnittdarstellung.

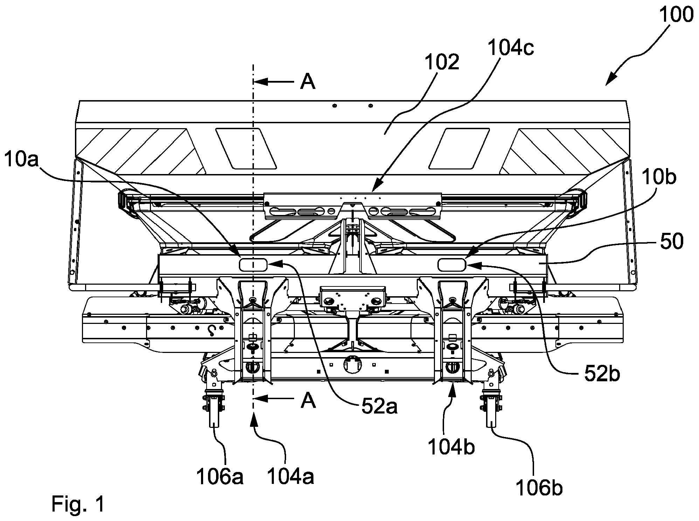

Die Fig. 1 zeigt ein als Düngerstreuer ausgebildetes landwirtschaftliches Gerät 100. Das landwirtschaftliche Gerät 100 weist einen Vorratsbehälter 102 zum Bevorraten des auszubringenden Streuguts auf. Das landwirtschaftliche Gerät 100 ist über die Kupplungseinrichtung 104a-104c mit einem Trägerfahrzeug, wie beispielsweise einem Traktor, koppelbar. Ferner weist das landwirtschaftliche Gerät 100 Räder 106a, 106b auf, auf welche das landwirtschaftliche Gerät 100 abgestellt werden kann.

Außerdem weist das landwirtschaftliche Gerät 100 zwei Elektronikeinheiten (verdeckt) auf, welche innerhalb eines als Gehäuse ausgebildeten Objekts 50 angeordnet sind. Das als Gehäuse ausgebildete Objekt 50 stellt das Hauptrohr des Düngerstreuers dar und weist zwei Ausnehmungen 52a, 52b auf, über welche die Elektronikeinheiten zugänglich sind. Die Elektronikeinheiten sind als Maschinenrechner ausgebildet und dienen unter anderem der Steuerung der Schleuderscheiben des landwirtschaftlichen Geräts 100.

Im Bereich der Ausnehmungen 52a, 52b ist jeweils eine Vorrichtung 10a, 10b zum Abdichten der jeweiligen Ausnehmung 52a, 52b angeordnet. Mittels der Vorrichtungen 10a, 10b werden die Elektronikeinheiten in dem Hauptrohr vor Feuchtigkeit geschützt.

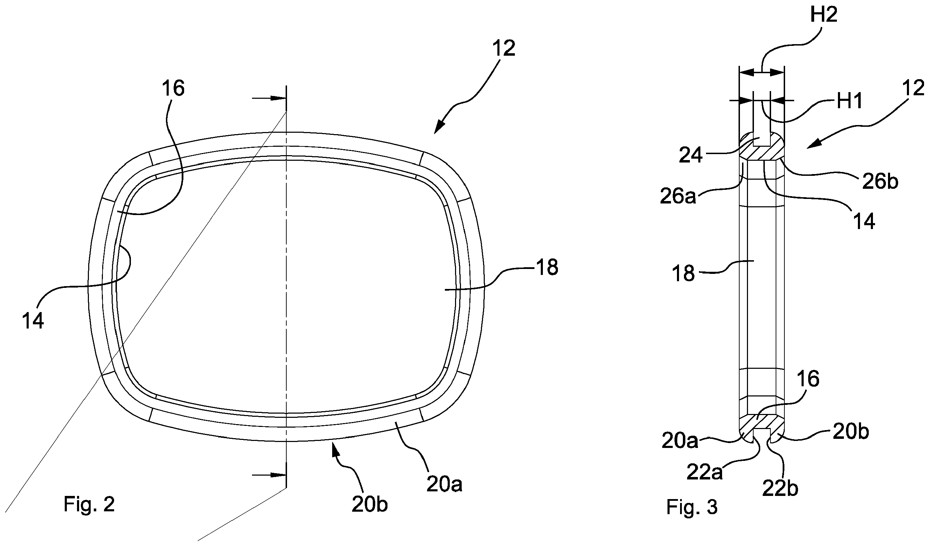

Die Fig. 2 und die Fig. 3 zeigen ein Aufnahmeteil 12 einer Vorrichtung 10 zum Abdichten einer Ausnehmung 52. Beispielsweise umfassen die in der Fig. 1 dargestellten Vorrichtungen 10a, 10b jeweils ein solches Aufnahmeteil 12.

Das Aufnahmeteil 12 ist umlaufend ausgebildet und weist eine Ringform auf. Ferner weist das Aufnahmeteil 12 eine Öffnung 18 auf, in welche ein Deckel 30 einsetzbar ist. Das Aufnahmeteil 12 weist eine der Öffnung 18 zugewandte Kontaktfläche 14 auf, welche von einem Materialabschnitt 16 getragen wird. Die Kontaktfläche 14 weist in den seitlichen Außenbereichen jeweils eine Fase 26a, 26b auf.

Außerdem ist das Aufnahmeteil 12 dazu eingerichtet, an der Außenkontur einer Ausnehmung 52 befestigt zu werden. Hierzu weist das Aufnahmeteil 12 eine obere Befestigungslippe 20a und eine untere Befestigungslippe 20b auf. Die obere Befestigungslippe 20a bildet eine obere Anschlagsfläche 22a für das Objekt 50 aus. Die untere Befestigungslippe 20b bildet eine untere Anschlagsfläche 22b für das Objekt 50 aus. Zwischen der oberen Befestigungslippe 20a und der unteren Befestigungslippe 20b ist eine Aufnahmenut 24 angeordnet, wobei die Aufnahmenut 24 zur Aufnahme der Außenkontur der Ausnehmung 52 ausgebildet ist. Die Aufnahmenut 24 weist eine Höhe H1 auf, wobei das Aufnahmeteil 12 eine Gesamthöhe H2 aufweist.

Das Aufnahmeteil 12 ist einstückig und aus einem elastisch verformbaren Kunststoff, nämliche einem Elastomer, ausgebildet.

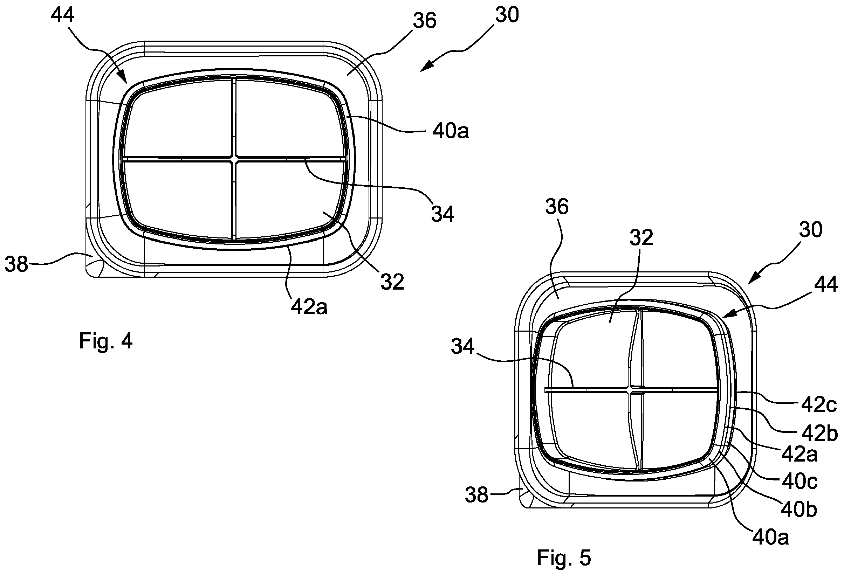

Die Fig. 4 und die Fig. 5 zeigen einen Deckel 30 einer Vorrichtung 10 zum Abdichten einer Ausnehmung 52. Beispielsweise umfassen die in der Fig. 1 dargestellten Vorrichtungen 10a, 10b jeweils einen solchen Deckel 30.

Der Deckel 30 ist dazu eingerichtet, reversibel und zerstörungsfrei lösbar in ein Aufnahmeteil 12 eingesetzt zu werden. Der Deckel 30 weist einen sich über das Aufnahmeteil 12 nach außen erstreckenden Überstand 36 auf, welcher das Aufnahmeteil 12 im eingesetzten Zustand des Deckels 30 verdeckt. Außerdem umfasst der Deckel 30 in dem die Ausnehmung 52 bedeckenden Materialabschnitt 32 als Versteifungsrippen ausgebildete Versteifungselemente 34 auf. Darüber hinaus weist der Deckel 30 eine Grifflasche 38 auf, welche von einem Benutzer zum Lösen und Entnehmen des Deckels 30 händisch greifbar ist.

Der Deckel 30 umfasst insgesamt drei voneinander beabstandete, sich nach außen erstreckende und umlaufende Rippen 40a-40c, wobei jede Rippe 40a-40c jeweils einen Kontaktabschnitt 42a-42c des Deckels 30 trägt. Die Kontaktabschnitte 42a-42c stehen im eingesetzten Zustand des Deckels 30 mit einer Kontaktfläche 14 eines Aufnahmeteils 12 in Kontakt. Die Rippe 40a weist einen größeren Außenkonturumfang als die Rippen 40b, 40c auf. Die Außenkonturumfänge der Rippen 40b, 40c stimmen im Wesentlichen überein.

Die Rippen 40a-40c sind an einem umlaufenden Kragen 44 angeordnet, welcher sich nach Einsetzen des Deckels 30 durch die Ausnehmung 52 in dem Objekt 50 erstreckt.

Der Deckel 30 ist einstückig und aus einem formstabilen Kunststoff, nämlich einem Thermoplast, ausgebildet.

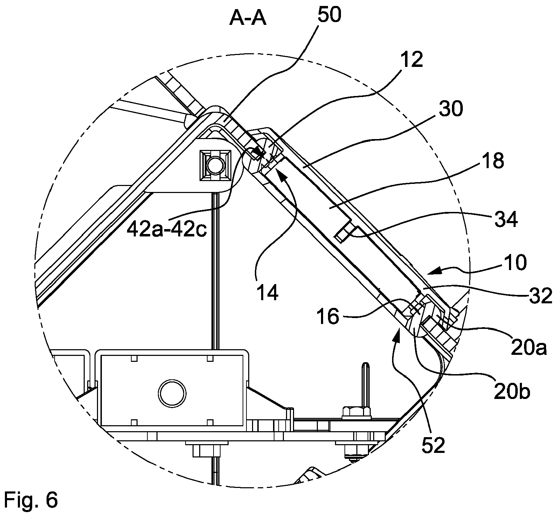

Die Fig. 6 zeigt eine Vorrichtung 10 zum Abdichten einer Ausnehmung 52 in einem Objekt 50. Die Vorrichtung 10 umfasst ein Aufnahmeteil 12 und einen Deckel 30.

Das Aufnahmeteil 12 ist an der Außenkontur der Ausnehmung 52 an dem Objekt 50 befestigt. Der Deckel 30 ist reversibel und zerstörungsfrei lösbar in das Aufnahmeteil 12 eingesetzt. Das Aufnahmeteil 12 weist eine Kontaktfläche 14 auf, welche mit drei Kontaktabschnitten 42a-42c des Deckels 30 in Kontakt steht.

Der die Kontaktfläche 14 tragende Materialabschnitt 16 des Aufnahmeteils 12 und die Kontaktabschnitte 42a-42c des Deckels 30 sind aus unterschiedlichen Materialien ausgebildet und weisen unterschiedliche Verformungseigenschaften auf. Die Kontaktfläche 14 des Aufnahmeteils 12 ist nämlich aus einem weicheren Material ausgebildet als die Kontaktabschnitte 42a-42c des Deckels 30. Aufgrund der jeweiligen Einstückigkeit des Aufnahmeteils 12 und des Deckels 30 ist das gesamte Aufnahmeteil 12 aus einem weicheren Material ausgebildet der Deckel 30.

Die Kontaktabschnitte 42a-42c des Deckels 30 werden von Rippen 40a-40c getragen und weisen ein Übermaß gegenüber der Kontur der Kontaktfläche 14 des Aufnahmeteils 12 und der Außenkontur der Ausnehmung 52 in dem Objekt 50 auf. Auf diese Weise wird ein umlaufender Abdichtbereich ausgebildet, welcher eine flüssigkeitsdichte Verbindung zwischen dem Aufnahmeteil 12 und dem Deckel 30 bereitstellt. Aufgrund des Übermaßes kommt es beim Einsetzen des Deckels 30 in das Aufnahmeteil 12 zu einer elastischen Verformung des die Kontaktfläche 14 tragenden Materialabschnitts 16 des Aufnahmeteils 12. Es wird somit eine kraftschlüssige Verbindung zwischen dem Deckel 30 und dem Aufnahmeteil 12 erzeugt. Dabei verkrallen sich die Kontaktabschnitte 42a-42c des Deckels 30 in die Kontaktfläche 14 des Aufnahmeteils 12. Aufgrund des Übermaßes der Kontaktabschnitte 42a-42c des Deckels 30 wird das Aufnahmeteil 12 beim Einsetzten des Deckels 30 gegen die Kontur der Ausnehmung 52 in dem Objekt 50 gedrückt. Der Deckel 30 kann werkzeuglos von dem Aufnahmeteil 12 gelöst und entnommen werden.

Alternativ kann der Deckel 30 auch direkt in die Ausnehmung 52 in dem Objekt 50 eingesetzt werden, ohne dass zuvor das Aufnahmeteil 12 befestigt wurde.

### Bezugszeichenliste

- 10, 10a, 10b: Vorrichtung
- 12: Aufnahmeteil
- 14: Kontaktfläche
- 16: Materialabschnitt
- 18: Öffnung
- 20a, 20b: Befestigungslippen
- 22a, 22b: Anschlagsflächen
- 24: Aufnahmenut
- 26a,26b: Fasen
- 30: Deckel
- 32: Materialabschnitt
- 34: Versteifungselemente
- 36: Überstand
- 38: Grifflasche
- 40a-40c: Rippen
- 42a-42c: Kontaktabschnitte
- 44: Kragen
- 50: Objekt
- 52, 52a, 52b: Ausnehmungen

- 100: landwirtschaftliches Gerät
- 102: Vorratsbehälter
- 104a-104c: Kupplungseinrichtung
- 106a, 106b: Räder

- H1: Höhe der Aufnahmenut
- H2: Gesamthöhe des Aufnahmeteils

## Patentansprüche

1. Vorrichtung (10, 10a, 10b) zum Abdichten einer Ausnehmung (52, 52a, 52b) in einem Objekt (50), mit
- einem umlaufenden Aufnahmeteil (12), welches dazu eingerichtet ist, an der Außenkontur der Ausnehmung (52, 52a, 52b) an dem Objekt (50) befestigt zu werden; und
- einem Deckel (30), welcher dazu eingerichtet ist, reversibel und zerstörungsfrei lösbar in das Aufnahmeteil (12) eingesetzt zu werden;
wobei das Aufnahmeteil (12) eine Kontaktfläche (14) aufweist, welche im eingesetzten Zustand des Deckels (30) mit zumindest einem Kontaktabschnitt (42a-42c) des Deckels (30) in Kontakt steht; **dadurch gekennzeichnet, dass** der die Kontaktfläche (14) tragende Materialabschnitt (16) des Aufnahmeteils (12) und der zumindest eine Kontaktabschnitt (42a-42c) des Deckels (30) unterschiedliche Verformungseigenschaften aufweisen.

2. Vorrichtung (10, 10a, 10b) nach Anspruch 1,
**dadurch gekennzeichnet, dass** der die Kontaktfläche (14) tragende Materialabschnitt (16) des Aufnahmeteils (12) aus einem weicheren Material ausgebildet ist als der zumindest eine Kontaktabschnitt (42a-42c) des Deckels (30).

3. Vorrichtung (10, 10a, 10b) nach Anspruch 1 oder 2,
**dadurch gekennzeichnet, dass** die Kontaktfläche (14) des Aufnahmeteils (12) und/oder der zumindest eine Kontaktabschnitt (42a-42c) des Deckels (30) umlaufend ausgebildet sind.

4. Vorrichtung (10, 10a, 10b) nach einem der vorstehenden Ansprüche,
**dadurch gekennzeichnet, dass** der zumindest eine Kontaktabschnitt (42a-42c) des Deckels (30) ein Übermaß gegenüber der Kontur der Kontaktfläche (14) des Aufnahmeteils (12) und/oder der Außenkontur der Ausnehmung (52, 52a, 52b) in dem Objekt (50) aufweist.

5. Vorrichtung (10, 10a, 10b) nach einem der vorstehenden Ansprüche,
**dadurch gekennzeichnet, dass** der Deckel (30) und/oder das Aufnahmeteil (12) jeweils teilweise oder vollständig aus Kunststoff ausgebildet sind.

6. Vorrichtung (10, 10a, 10b) nach einem der vorstehenden Ansprüche,
**dadurch gekennzeichnet, dass** der Deckel (30) und/oder das Aufnahmeteil (12) jeweils einstückig ausgebildet sind.

7. Vorrichtung (10, 10a, 10b) nach einem der vorstehenden Ansprüche,
**dadurch gekennzeichnet, dass** der Deckel (30) eine sich nach außen erstreckende und vorzugsweise umlaufende Rippe (40a-40c) umfasst, welche einen Kontaktabschnitt (42a-42c) des Deckels (30) trägt.

8. Vorrichtung (10, 10a, 10b) nach einem der vorstehenden Ansprüche,
**dadurch gekennzeichnet, dass** der Deckel (30) mehrere voneinander beabstandete, sich nach außen erstreckende und vorzugsweise umlaufende Rippen (40a-40c) umfasst, wobei jede Rippe (40a-40c) jeweils einen Kontaktabschnitt (42a-42c) des Deckels (30) trägt.

9. Vorrichtung (10, 10a, 10b) nach Anspruch 7 oder 8,
**dadurch gekennzeichnet, dass** die eine oder die mehreren Rippen (40a-40c) an einem, vorzugsweise umlaufenden, Kragen (44) angeordnet sind, welcher sich nach Einsetzen des Deckels (30) zumindest teilweise durch die Ausnehmung (52, 52a, 52b) in dem Objekt (50) erstreckt.

10. Vorrichtung (10, 10a, 10b) nach einem der vorstehenden Ansprüche,
**dadurch gekennzeichnet, dass** der Deckel (30) einen sich über das Aufnahmeteil (12) nach außen erstreckenden Überstand (36) aufweist, welcher das Aufnahmeteil (12) im eingesetzten Zustand des Deckels (30) zumindest abschnittsweise verdeckt.

11. Vorrichtung (10, 10a, 10b) nach einem der vorstehenden Ansprüche,
**dadurch gekennzeichnet, dass** das Aufnahmeteil (12) eine obere Befestigungslippe (20a), welche eine obere Anschlagsfläche (22a) für das Objekt (50) ausbildet, und/oder eine untere Befestigungslippe (20b), welche eine untere Anschlagsfläche (22b) für das Objekt (50) ausbildet, aufweist.

12. Vorrichtung (10, 10a, 10b) nach einem der vorstehenden Ansprüche,
**dadurch gekennzeichnet, dass** der Deckel (30) werkzeuglos von dem Aufnahmeteil (12) gelöst und entnommen werden kann.

13. Landwirtschaftliches Gerät (100), mit
- einer Elektronikeinheit, welche innerhalb eines Gehäuses angeordnet ist, wobei das Gehäuse eine Ausnehmung (52, 52a, 52b) aufweist, über welche die Elektronikeinheit zugänglich ist; und
- einer Vorrichtung (10, 10a, 10b) zum Abdichten der Ausnehmung (52, 52a, 52b) des Gehäuses;
**dadurch gekennzeichnet, dass** die Vorrichtung (10, 10a, 10b) zum Abdichten der Ausnehmung (52, 52a, 52b) des Gehäuses nach einem der vorstehenden Ansprüche ausgebildet ist.

14. Landwirtschaftliches Gerät (100) nach Anspruch 13,
**dadurch gekennzeichnet, dass** das landwirtschaftliche Gerät (100) als Düngerstreuer ausgebildet ist, wobei das Gehäuse vorzugsweise als Hauptrohr des Düngerstreuers ausgebildet ist, in welchem die als Maschinenrechner ausgebildete Elektronikeinheit angeordnet ist.
